# EUROPÄISCHE PATENTSCHRIFT

(11) **EP 0 742 440 B1**
(45) Veröffentlichungstag und Bekanntmachung des Hinweises auf die Patenterteilung: **20.02.2002**
(21) Anmeldenummer: 96107027.3
(22) Anmeldetag: 03.05.1996
(51) Int. Cl.: G01R 15/18, G01R 19/20, G01R 15/20

(54) **Kompensationsstromwandlung**
Compensated current conversion
Conversion compensée de courant

(30) Priorität: 09.05.1995 DE 29507675 U; 18.12.1995 DE 29520066 U
(43) Veröffentlichungstag der Anmeldung: 13.11.1996
(73) Patentinhaber: Vacuumschmelze GmbH, 63450 Hanau (DE)
(72) Erfinder: Hartwig, Hagen, Dipl.-Ing., 91056 Erlangen (DE)
(74) Vertreter: Neunert, Peter Andreas

(56) Entgegenhaltungen:
- EP-A- 0 510 376
- EP-A- 0 686 850
- WO-A-94/23305
- WO-A-95/12819
- DE-A- 3 435 267
- DE-A- 4 229 948
- DE-U- 29 506 883
- ELEKTROTECHNISCHE ZEITSCHRIFT - ETZ, Bd. 100, Nr. 24, November 1979, Seiten 1390-1394, XP002029215 LISSER J ET AL: "NULLFLUSS-STROMWANDLER ZUR MESSUNG VON GLEICH-UND WECHSELSTROEMEN"

## Beschreibung

Die Erfindung bezieht sich auf eine Vorrichtung zur Kompensationsstromwandlung, bestehend aus einem Magnet-Feld-Sensor, einer darauffolgenden Reglerstufe, einer Verstärkerstufe, insbesondere einer symmetrisch gespeisten Stufe, und einer Bürde in Form eines Widerstandes, über dem eine einem Eingangsstrom proportionale Spannung abfällt.

In der internationalen Anmeldung WO 95/12819 wird ein Stromsensor beschrieben, der zur Messung eines Primärstroms geeignet ist und wenigstens einen magnetischen kreis aufweist, der mit der den Primärstrom führenden Leitung verkoppelt ist. Dieser Kreis weist einen Luftspalt auf, in dem eine Hallsonde angeordnet ist. Eine Induktivität ist mit dem magnetischen Kreis gekoppelt. Die Hallsonde und die Induktivität sind Teile einer Meßschaltung, die mindestens eine Stromquelle für die Induktivität umfaßt, um einen Kompensationsstrom in der Induktivität zu erzeugen. Die Meßschaltung weist ferner eine Kontrollschaltung zum Kontrollieren der Stromquelle als Funktion eines durch die Hallsonde erzeugten Signals, um das magnetische Feld im Luftspalt aufzuheben.

Bei Kompensationsstromwandlern, welche in der Regel der Wandlung großer Ströme im Amperebereich in proportionale kleinere Ströme dienen, besitzen in der obengenannten herkömmlichen Bauart den Nachteil, daß der zu wandelnde Primärstrom konstruktionsbedingt nach oben hin limitiert ist. Limitierendes Kriterium für den maximal abbildbaren Primärstrom ist der Innenwiderstand der Kompensationswicklung, welche wie der zu messende Primärstrom auch, auf einem gemeinsamen magnetischen Kern angebracht ist. Die Kompensationswicklung und damit deren Innenwiderstand wiederum hängt von dem zur Verfügung stehenden Wicklungsraum ab, den der verwendete magnetische Kern aufweist.

Das hat zur Folge, daß zur Leistungssteigerung von herkömmlichen Kompensationsstromwandlern und der Verarbeitung eines höheren Primärstroms ein entsprechend größerer Wicklungsraum zur Verfügung gestellt werden muß, was jedoch sowohl hinsichtlich des Platzbedarfs als auch der dadurch bedingten Kosten Nachteile mit sich bringt. Das Abbilden eines höheren Primärstromes erfordert einen höheren Kompensationsstrom, welcher wiederum durch die vorhandene Spannung und den gegebenen Wicklungswiderstand begrenzt ist. Aus diesem Grunde wird herkömmlicherweise entweder die Bauform vergrößert oder aber die Versorgungsspannungen werden erhöht, was aufwendige Sonderlösungen bei Netzteil oder einer daran angeschlossenen Auswerteelektronik erfordert.

In WO-A-9423305 wird eine Vorrichtung zur Kompensationsstromwandlung beschrieben, die einen Magnetfeldsensor, eine darauf folgende Reglerstufe, eine Verstärkerstufe und eine Bürde in Form eines Widerstandes aufweist, über dem eine einem Eingangsstrom proportionale Spannung abfällt. Die Vorrichtung weist eine Gegentaktendstufe mit sogenannter schwimmender Bürde auf, wobei die Gegentaktverstärkerstufe durch eine invertierende Verstärkerstufe gebildet wird. Die Verstärkerstufe wird symmetrisch gespeist. Mit dieser Vorrichtung können höhere Primärströme abgebildet werden, ohne daß die Dimension und dadurch bedingt die Kosten der Vorrichtung zunehmen und ohne daß Erhöhungen der Versorgungsspannung über das übliche Maß hinaus notwendig werden.

Will man einen solchen Kompensationsstromwandler besser ausnutzen, indem man beispielsweise kleinere Kompensationsstromwandler mit höheren Eingangsströmen beaufschlagt, um größere Wandler zu vermeiden und damit Platz und Kosten zu sparen, so steigt dadurch die Leistungsaufnahme für die Kompensationswicklung und entsprechend auch die Verlustleistung in der Ansteuerung. Dieses Problem stellt sich auch bei solchen Kompensationsstromwandlern, bei denen ein Gegentaktbetrieb vorgesehen ist, wodurch der verarbeitbare Eingangsstrom bei unveränderter Baugröße verdoppelt wird.

Das Verdoppeln von Kompensationsstrom und angelegter Spannung führt jedoch dazu, daß die vierfache Leistung zugeführt wird. Im Normalbetrieb wird jedoch ein Großteil der zugeführten Leistung an der Gegentaktendstufe in Wärme umgesetzt. Wie bei einem Längsregler tritt die nicht benötigte Spannung als Verlustspannung über der Gegentaktendstufe auf. Als Produkt mit dem Kompensationsstrom ist diese Verlustleistung über einen weiten Arbeitsbereich konstant.

Herkömmlicherweise wird diesem Problem des erhöhten Leistungsbedarfs durch stärker dimensionierte Stromversorgungen und eine Ansteuerelektronik mit stärkeren Endstufen sowie größeren Kühlflächen begegnet. Dadurch werden zum einen höhere Kosten verursacht und zum anderen ist das Auftreten der Verlustleistung als solche nicht gelöst. Diese wird lediglich abgeführt.

Eine andere Vorgehensweise besteht darin, einen Teil der Verlustleistung aus der Ansteuerelektronik auf einen Vorwiderstand zu verlagern, welcher in Serie zum Bürdenwiderstand geschaltet ist. Jedoch wird auch dabei die Tatsache, daß eine Verlustleistung anfällt, nicht vermieden. Diese wird ebenfalls lediglich abgeführt.

Aufgabe der Erfindung ist es daher, eine Vorrichtung zur Kompensationsstromwandlung der eingangs genannten Art dahingehend zu verbessern, daß die auftretende Verlustleistung minimiert wird und zugleich hohe Primärströme abgebildet werden können. Dabei sollen auch möglichst weiterhin handelsübliche Standardkomponenten, welche aufgrund ihrer hohen Verfügbarkeit besonders preisgünstig sind, einsetzbar bleiben.

Gemäß der Erfindung wird diese Aufgabe durch die Merkmale des Anspruchs 1 gelöst.

In einer ersten vorteilhaften Ausgestaltung der Erfindung werden die neu hinzugefügten Baugruppen besonders einfach in das bestehende Konzept der eingangs genannten Art integriert und es wird auf preisgünstige Standardbaugruppen zurückgegriffen. Darüber hinaus erfolgt die Anschaltung der zusätzlichen Baugruppen auf besonders einfache Art und Weise. Dies wird dadurch gelöst, daß
2.1 die Bürde in Form des Widerstandes zwischen die Ausgänge der ersten Verstärkerstufe und der invertierenden Verstärkerstufe geschaltet ist,
2.2 die Bürde in Form des Widerstandes zwischen die beiden Eingänge des Differenzverstärkers geschaltet ist.

Eine weitere vorteilhafte Ausgestaltung der Erfindung vermeidet, daß bei voller Ausnutzung des erfindungsgemäßen Kompensationsstromwandlers das sogenannte "Latch up"-Kriterium überschritten wird. Dieses vermeidet, daß beim Einschalten durch unterschiedliches Hochlaufen der positiven und negativen Versorgungsspannung sowie durch unkontrollierte Überschwinger der Reglerstufe ein zu hoher Kompensationsstrom auftritt und dadurch bedingt die Elektronik der Auswertestufe eventuell auch in den "Latch up"-Zustand geht. Dies wird dadurch verhindert, daß
3.1 die Reglerstufe und/oder Verstärkerstufen durch eine Latch-up-Kontrolle gesteuert werden, welche insbesondere die Symmetrie der positiven und negativen Versorgungsspannung und den Reglersummenpunkt auf irreguläre Werte hin überwacht.

Eine weitere vorteilhafte Ausgestaltung der vorliegenden Erfindung ermöglicht den Aufbau eines besonders effektiven Kompensationsstromwandlers, welcher eingangsseitig durch besonders günstige Anordnung der Baugruppen einen besonders preisgünstigen Aufbau des Kompensationsstromwandlers ermöglicht. Dies wird dadurch gelöst, daß
4.1 der Primärstrom mit einer Wicklung durch einen magnetischen Ringkern, insbesondere einen solchen mit Luftspalt, geführt wird,
4.2 der Kompensationsstrom mit mehreren Wicklungen durch denselben magnetischen Ringkern geführt wird.

In einer weiteren vorteilhaften Ausgestaltung der Erfindung wird ein besonders vorteilhafter Frequenzbereich angegeben, welcher eine optimale Minimierung der Verlustleistung erlaubt. Dies wird erreicht, indem
5.1 die Taktfrequenz im Bereich zwischen 100 kHz und 200 kHz vorgegeben ist.

In einer weiteren vorteilhaften Ausgestaltung der Erfindung wird die Taktfrequenz unter besonders vorteilhafter Ausnutzung bereits vorhandener Bauelemente generiert. Dies wird dadurch erreicht, daß
6.1 die Taktfrequenz von einem zur Erregung des Magnetfeld-Sensors vorgesehenen Oszillator ableitbar ist.

In einer weiteren vorteilhaften Ausgestaltung der Erfindung erfolgt eine besonders effektive Weiterverarbeitung des Taktens, wobei wiederum bereits vorhandene Bauelemente zur Realisierung herangezogen werden, was eine besonders preisgünstige Lösung ermöglicht. Dies wird dadurch herbeigeführt, daß
7.1 das Takten pulsweitenmodulierbar ist.

In einer weiteren vorteilhaften Ausgestaltung der Erfindung wird erreicht, daß die Pulsweitenmodulation variierbar ist, indem
8.1 zwei Komparatoren zur Einstellung des Puls-Pausen-Verhältnisses vorgesehen sind.

Eine weitere vorteilhafte Ausgestaltung der vorliegenden Erfindung ermöglicht den Aufbau eines besonders kleindimensionierten Kompensationsstromwandlers, welcher die Vorteile gemäß der vorliegenden Erfindung besonders platzsparend und somit preisgünstig ermöglicht. Dies wird dadurch erreicht, indem
9.1 diese in einem anwenderspezifizierten integrierten Schaltkreis integrierbar ist.

Die mit der Erfindung erzielten Vorteile bestehen insbesondere darin, daß der abbildbare Primärstrom eines Kompensationsstromwandlers der eingangs genannten Art erheblich erhöht werden kann, ohne daß die Dimension des Kompensationsstromwandlers erheblich erhöht werden muß, was sehr viel höhere Kosten nach sich ziehen würde, und daß ein Erhöhen der Versorgungsspannungen über das übliche Maß hinaus vermieden werden kann, wodurch der Einsatz handelsüblicher, auf diese üblichen Versorgungsspannungen ausgelegter Standardbaugruppen nach wie vor möglich bleibt. Auf diese Weise können aufwendige Sonderlösungen bei Netzteil und Auswerteelektronik vermieden werden. Weiterhin wird aufgrund einer besonderen konstruktiven Auslegung des Kompensationsstromwandlers für höhere Eingangsströme die auftretende erhöhte Verlustleistung nicht lediglich abgeführt, sondern diese wird minimiert. Dies wird durch besonders trickreiche Schaltungsmaßnahmen unter vielfacher Ausnutzung bereits vorhandener Bauelemente erreicht. Auch bleibt der Einsatz handelsüblicher, auf übliche Versorgungsspannungen ausgelegter Standardbaugruppen nach wie vor möglich. Auf diese Weise können aufwendige Sonderlösungen bei Netzteil und Auswerteelektronik vermieden werden.

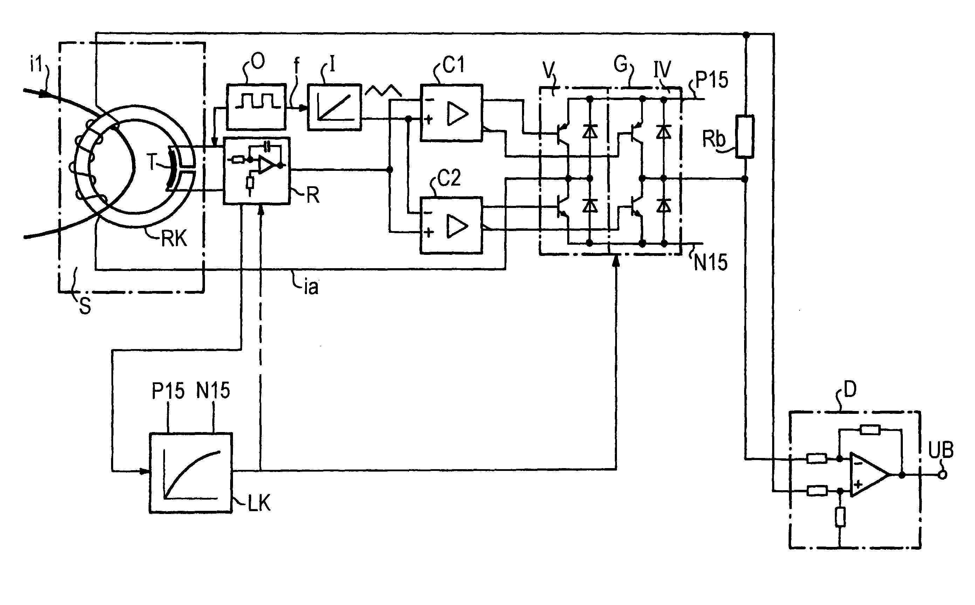

Weitere Einzelheiten und Vorteile ergeben sich aus den im folgenden beschriebenen Ausführungsbeispielen der Erfindung und aus der Figur. Dabei zeigt:
die Figur eine Schaltungsanordnung eines Kompensationsstromwandlers mit einer pulsweitenmodulierten getakteten Gegentaktendstufe mit "schwimmender" Bürde und "Latch up"-Kontrolle.

In der Darstellung gemäß der Figur ist eine Schaltungsanordnung eines Kompensationsstromwandlers mit einer pulsweitenmoduliert getakteten Gegentaktendstufe zur Minimierung der Verlustleistung und Latch up-Kontrolle gezeigt. Die Gegentaktendstufe G wird durch die Endstufen V, IV eines Verstärkerstufe C1, C2, V und einer invertierenden Verstärkerstufe C1, C2, IV gebildet. Dabei wird ein Primärstrom i1 von einem Magnet-Feld-Sensor S gemessen, indem der Primärstrom i1 durch einen magnetischen Ringkern RK mit Luftspalt geführt wird. Durch eine über dem Luftspalt angeordnete T-Feld-Sonde T wird der Primärstrom i1 erfaßt und einer Reglerstufe R zugeführt. Der dort ermittelte Wert, welcher den Kompensationsstrom ia darstellt, wird daraufhin einer Gegentaktendstufe G zugeführt, welche durch eine symmetrische Spannungsversorgung mit positiver Spannung P15 und negativer Versorgungsspannung N15 von 15 V gespeist wird. Dies geschieht jedoch nicht auf direktem Wege, sondern über zwei Komparatoren C1 und C2, welche jeweils einen negierten und einen nicht-negierten Ausgang aufweisen. Die Komparatoren sind vorzugsweise mittels Operationsverstärkern aufgebaut. Das dem Kompensationsstrom ia proportionale Ausgangssignal der Reglerstufe R wird einem der Komparatoren an dessen invertierendem und dem anderen Komparator an dessen nichtinvertierendem Eingang zugeführt. Im vorliegenden Ausführungsbeispiel ist Komparator C1 am invertierenden und Komparator C2 am nichtinvertierenden Eingang mit dem Ausgangssignal der Reglerstufe R beaufschlagt.

Die zum Takten benötigte Frequenz f, welche bevorzugterweise im Frequenzbereich zwischen 100 kHz und 200 kHz liegt, jedoch auch - abhängig von der Dimensionierung des Kompensationsstromwandlers - andere Frequenzen umfassen kann, wird aus der bereits vorhandenen Ansteuer- und Auswerteelektronik gewonnen, die der besseren Übersichtlichkeit halber in der Darstellung gemäß der Figur nicht im Detail dargestellt ist. Diese Ansteuer- und Auswerteelektronik besitzt in der Regel einen Oszillator O zur Erregung der T-Feld-Sonde T. Ist ein solcher Oszillator O jedoch nicht vorgesehen, so wird er separat hinzugefügt.

Zu diesem Oszillator O, von dem die benötigte Frequenz f abgeleitet wird, kommt ein Integrator I hinzu, der vom Frequenzsignal f angesteuert wird und der ein Dreiecksignal erzeugt, welches in der Darstellung gemäß der Figur erläuternd am Ausgang skizziert ist. Dieser Integrator I kann beispielsweise aus einem RC-Glied aufgebaut sein.

Die beiden Komparatoren C1 und C2 werden an ihren noch unbeschalteten Eingängen mit dem Dreiecksignal des Integrators I beaufschlagt. Die Komparatoren C1 und C2 dienen somit der Erzeugung von Puls-Pausen-Signalen. Das Puls-Pausen-Verhältnis ist bei konstanter Frequenz des Dreiecksignales über den am zweiten Eingang der Komparatoren anliegenden Spannungswert bestimmbar, welcher durch den Regler R vorgebbar und variierbar ist. Die Komparatoren C1 und C2 besitzen Totzeiten zueinander und sind gegeneinander verriegelt, damit gegenüberliegende Transistoren in der Gegentaktendstufe G nicht gleichzeitig durchschalten können. Diese Gegentaktendstufe G kann als Brückenendstufe ausgebildet sein und als Endstufentransistoren können beispielsweise bipolare Transistoren oder MOSFETs verwendet werden. Die Gegentaktendstufe G wird von den Ausgangssignalen der Komparatoren C1 und C2 so angesteuert, daß jeweils einer der Ausgänge der Gegentaktendstufe G positive Ausgangsspannung P15 und der andere Ausgang negative Ausgangsspannung N15 führt. Die Polarität wechselt mit dem Pulse-Pause-Wechsel im Takt der Frequenz f. Bei dem so erreichten pulsweitenmodulierten Takten der Gegentaktendstufe G treten nur noch vergleichsweise geringe Durchlaß- und Schaltverluste auf, wodurch die Verlustleistung erheblich reduziert wird.

Der Kompensationsstrom ia wird von einem Ausgang der Gegentaktendstufe G aus mit mehreren Windungen über den magnetischen Ringkern R geführt. Die Windungszahl des den Kompensationsstrom ia führenden Leiters ist dabei um ein Vielfaches größer als die Windungszahl des den Primärstrom i1 führenden Leiters. Der über den magnetischen Ringkern RK geführt Kompensationsstrom ia wird daraufhin einer Bürde in Form eines elektrischen Widerstandes Rb zugeführt. Der von der Reglerstufe R vorgegebene Spannungsmittelwert stellt sich durch ein entsprechendes Puls-Pausen-Verhältnis ein und die hohe Induktivität der Kompensationswicklung, welche in der Regel zwischen 300 und 1600 mH beträgt, stellt eine Glättung des Stromes sicher. Damit wird die ohnehin vorhandene Kompensationsstromwicklung ohne Mehraufwand für einen weiteren positiven Effekt genutzt.

Der Bürdenwiderstand Rb ist herkömmlicherweise mit Massepotential M verbunden. Die erfindungsgemäße Vorrichtung eines Kompensationsstromwandlers vermeidet diesen negativen Umstand, indem nunmehr über die Gegentaktendstufe G beide Polaritäten P15 und N15 gleichzeitig den Kompensationsstrom ia treiben. Die Bürde Rb wird zwischen die beiden Ausgänge der Gegentaktendstufe G geschaltet, wobei einer der Ausgänge, wie oben beschrieben, vorher über mehrere Wicklungen zur Kompensation des magnetischen Feldes im Ringkern RK als Kompensationsstrom ia über diesen Ringkern RK geführt wird. Das Treiben des Kompensationsstromes ia mit beiden Polaritäten P15 und N15 der Versorgungsspannung gleichzeitig durch eine Gegentaktendstufe G verdoppelt den möglichen Kompensationsstrom ia und damit auch den abbildbaren Primärstrom i1. Die Bürde in Form des elektrischen Widerstandes Rb wird nunmehr nicht mehr gegen Masse geführt, sondern "schwimmend" über einen Differenzverstärker D abgegriffen.

Die beiden Eingänge des Differenzverstärkers D werden durch die beiden Ausgänge der Gegentaktendstufe G angesteuert. Der Differenzverstärker D verstärkt somit exakt die über der Bürde Rb abfallende Spannung. Die am Ausgang des Differenzverstärkers D erhaltene Bürdenspannung UB ist damit proportional zu einem gemessenen Primärstrom i1, wobei jedoch nunmehr größere Primärströme i1 gewandelt werden können. Der Aufbau des Differenzverstärkers D erfolgt vorzugsweise mit Hilfe eines oder mehrerer handelsüblicher Operationsverstärker.

Bei voller Ausnutzung des Kompensationsstromwandlers ohne "Latch-up"-Kontrolle K kann sich ergeben, daß das sogenannte "Latch up"-Kriterium überschritten wird. Dabei kann beim Einschalten durch ein unterschiedliches Hochlaufen der positiven und der negativen Versorgungsspannung P15 und N15 sowie durch unkontrollierte Überschwinger der Reglerstufe R ein so hoher Kompensationsstrom ia auftreten, daß das am magnetischen Ringkern RK angebrachte Sondensystem T, im Falle des Ausführungsbeispiels eine sogenannte T-Feld-Sonde, in Sättigung geht und dadurch eine falsche Polarität anzeigen kann. Dadurch wird jedoch der Regelsinn verkehrt, so daß die Auswerteelektronik, z.B. innerhalb der Regelstufe R, in den "Latch up"-Zustand geht.

Aus diesem Grunde wird die "Latch up"-Kontrolle LK hinzugefügt, die diesen Zustand durch Realisierung eines "Softstarts" ausschließt. Zusätzlich werden die Symmetrie und die Gleichzeitigkeit der positiven und der negativen Versorgungsspannung P15 und N15 überwacht. Ebenso wird der Reglersummenpunkt der Auswerteelektronik innerhalb der Reglerstufe R auf irreguläre Werte überwacht. Ein solcher irregulärer Wert ist beispielsweise dann gegeben, wenn eine größere Differenz zwischen dem invertierenden und dem nichtinvertierenden Eingang des Regler-Operationsverstärkers der Reglerstufe R auftritt, welche anzeigt, daß der Regelkreis nicht normal geschlossen ist, wie es z.B. in einem "Latch up"-Zustand der Fall ist. Aus diesem Grunde wird während des Softstarts sowie bei erkannten Abweichungen von den erwünschten Sollzuständen entweder die Verstärkerstufe oder die invertierende Verstärkerstufe oder aber beide Verstärkerstufen hochohmig oder auf Null Volt geschaltet. In dem in der Figur dargestellten Ausführungsbeispiel steuert die "Latch up"-Kontrolle LK die invertierende Verstärkerstufe an. An den Eingang der "Latch up"-Kontrolle LK wird der Reglersummenpunkt aus der Reglerstufe R geführt, welcher ein Abweichen von den gewünschten Sollzuständen signalisiert. Desweiteren werden die positive Versorgungsspannung P15 und die negative Versorgungsspannung N15 an die "Latch up"-Kontrolle LK geführt, um so einen Softstart sowie die Überwachung von Symmetrie und Gleichzeitigkeit der Versorgungsspannung vornehmen zu können. Bei einer bekannten Abweichung von einem der Sollzustände wird dann vom Ausgang der "Latch up"-Kontrolle LK die invertierende Verstärkerstufe angesteuert und, wie oben beschrieben, hochohmig oder auf Null Volt geschaltet.

Wahlweise kann die "Latch-up"-Kontrolle LK auch den Reglerausgang der Reglerstufe R begrenzen. Eine solche Möglichkeit ist in der Darstellung gemäß der Figur durch eine unterbrochen gezeichnete Verbindung angedeutet.

Die Gegentaktendstufe und deren Kühlflächen lassen sich so wesentlich verkleinern, was Platz und Kosten spart und darüber hinaus einen Einsatz bei Anwendungen möglich macht, die aus Platzgründen bisher nicht möglich waren. Auch läßt sich die gesamte Elektronik leicht in einen anwenderspezifizierbaren integrierten Schaltkreis ASIC integrieren. Darüber hinaus wird die Stromversorgung weniger belastet und kann kleiner ausfallen, was ebenfalls Kosten spart.

## Patentansprüche

1. Vorrichtung zur Kompensationsstromwandlung mit einem Magnet-Feld-Sensor (S), einer darauffolgenden Reglerstufe (R), einer Verstärkerstufe (C1, C2, V), insbesondere einer symmetrisch gespeisten Stufe, einer kompensationswicklung und einer Bürde in Form eines Widerstandes (Rb), über dem eine einem Eingangsstrom (i1) proportionale Spannung (UB) abfällt, wobei die Vorrichtung eine Gegentaktendstufe mit sogenannter schwimmender Bürde aufweist und wobei die Gegentaktverstärkerstufe durch eine invertierende Verstärkerstufe (C1, C2, IV), insbesondere eine symmetrisch gespeiste Verstärkerstufe, gebildet wird, **dadurch gekennzeichnet, daß** die Vorrichtung
1.1 einen auf die Gegentaktendstufe folgenden Differenzverstärker (D) aufweist,
1.2 zur Verlustleistungsminimierung Mittel (O, I, C1, C2) zum Takten der Verstärkerstufen vorgesehen sind und
1.3 die Induktivität der Kompensationswicklung zur Glättung dient.

2. Vorrichtung nach Anspruch 1, **dadurch gekennzeichnet, daß**
2.1 die Bürde in Form des Widerstandes (Rb) zwischen die Ausgänge der ersten Verstärkerstufe (C1, C2, V) und der invertierenden Verstärkerstufe (C1, C2, IV) geschaltet ist,
2.2 die Bürde in Form des Widerstandes (Rb) zwischen die beiden Eingänge des Differenzverstärkers (D) geschaltet ist.

3. Vorrichtung nach Anspruch 1 oder 2, **dadurch gekennzeichnet, daß**
3.1 die Reglerstufe (R) und/oder Verstärkerstufen (C1, C2, V, IV) durch eine Latch-up-Kontrolle (LK) gesteuert werden, welche insbesondere die Symmetrie der positiven und negativen Versorgungsspannung (P15,N15) und den Reglersummenpunkt auf irreguläre Werte hin überwacht.

4. Vorrichtung nach Anspruch 1, 2 oder 3, **dadurch gekennzeichnet, daß**
4.1 der Primärstrom (i1) mit einer Wicklung durch einen magnetischen Ringkern (RK), insbesondere einen solchen mit Luftspalt, geführt wird,
4.2 der Kompensationsstrom (ia) mit mehreren Wicklungen durch denselben magnetischen Ringkern (RK) geführt wird.

5. Vorrichtung nach Anspruch 1 bis 4, **dadurch gekennzeichnet, daß**
5.1 die Taktfrequenz (f) im Bereich zwischen 100 kHz und 200 kHz vorgegeben ist.

6. Vorrichtung nach Anspruch 1 bis 5, **dadurch gekennzeichnet, daß**
6.1 die Taktfrequenz (f) von einem zur Erregung des Magnetfeld-Sensors (S) vorgesehenen Oszillator (O) ableitbar ist.

7. Vorrichtung nach einem der vorstehenden Ansprüche 1 bis 6, **dadurch gekennzeichnet, daß**
7.1 die Mittel zum Takten pulsweitenmodulierbare Puls- Pausen- Signale erzeugen.

8. Vorrichtung nach Anspruch 7, **dadurch gekennzeichnet, daß**
8.1. zwei Komparatoren (C1,C2) zur Einstellung des PulsPausen-Verhältnisses vorgesehen sind.

9. Vorrichtung nach einem der vorhergehenden Ansprüche, **dadurch gekennzeichnet, daß** sie
9.1 in einem anwenderspezifizierten integrierten Schaltkreis integrierbare Elektronik aufweist.

## Claims

1. Device for compensating current transformation, with a magnetic field sensor (S), followed by a regulator stage (R), an amplifier stage (C1, C2, V), in particular a symmetrically fed stage, a compensation winding and a load in the form of a resistor (Rb), across which there is a voltage drop proportional to an input current (i1), such that the device comprises a push-pull output stage with a so-termed floating load and such that the push-pull amplifier stage is formed by an inverting amplifier stage (C1, C2, IV), in particular a symmetrically fed amplifier stage,
**characterised in that**
1.1 the device comprises a sum-and-difference amplifier (3) following the push-pull output stage,
1.2 to minimise the power loss means (O, I, C1, C2) are provided to cycle the amplifier stages, and
1.3 the inductance of the compensation winding serves for smoothing.

2. Device according to Claim 1,
**characterised in that**
2.1 the load in the form of the resistor (Rb) is connected between the outputs of the first amplifier stage (C1, C2, V) and of the inverting amplifier stage (C1, C2,IV)
2.2 the load in the form of the resistor (Rb) is connected between the two inputs of the sum-and-difference amplifier (D).

3. Device according to Claims 1 or 2,
**characterised in that**
3.1 the regulator stage (R) and/or the amplifier stages (C1, C2, V, IV) are controlled by a latch-up control (LK), which in particular monitors the symmetry of the positive and negative supply voltage (P15, N15) and the regulator summation point for irregular values.

4. Device according to Claims 1, 2 or 3,
**characterised in that**
4.1 the primary current (i1) flows through a winding with one turn around a magnetic ring core (RK), in particular a core with an air gap,

5. Device according to Claims 1 to 4,
**characterised in that**
5.1 the cycle frequency (f) is set in the range between 100 kHz and 200 Khz.

6. Device according to Claims 1 to 5,
**characterised in that**
6.1 the cycle frequency can be derived from an oscillator (O) provided to energise the magnetic field sensor (3).

7. Device according to any of the preceding Claims 1 to 6,
**characterised in that**
7.1 the means for cycling produce pulse width modulated pulse-pause signals.

8. Device according to Claim 7,
**characterised in that**
8.1 two comparators (C1, C2) are provided to adjust the pulse-pause ratio.

9. Device according to any of the preceding claims,
**characterised in that**
9.1 it comprises an electronic system that can be integrated into a user-specified integrated circuit.

## Revendications

1. Dispositif de conversion de courant à compensation comprenant un capteur de champ magnétique (S) suivi d'un étage de régulation (R), d'un étage amplificateur notamment d'un étage à alimentation symétrique (C1, C2, V), d'un enroulement de compensation et d'une charge sous la forme d'une résistance (Rb) qui donne une tension (Ub) proportionnelle à un courant d'entrée (i1), le dispositif comportant un étage en push-pull avec une charge flottante et l'étage amplificateur push-pull est formé par un étage amplificateur inverseur (C1, C2, IV) notamment un étage amplificateur avec une alimentation symétrique,
**caractérisé en ce que**
1.1 le dispositif comporte un amplificateur de différence (D) en aval de l'étage push-pull,
1.2 pour minimiser la puissance perdue, il comporte des moyens (O, I, C1, C2) pour cadencer les étages amplificateurs et
1.3 l'inductance de l'enroulement de compensation sert au lissage.

2. Dispositif de conversion de courant à compensation selon la revendication 1,
**caractérisé en ce que**
2.1 la charge est sous la forme d'une résistance (Rb) branchée entre les sorties du premier étage amplificateur (C1, C2, V) et l'étage amplificateur inversé (C1, C2, IV),
2.2 la charge est branchée sous la forme d'une résistance (Rb) entre les deux entrées de l'amplificateur de différence (D).

3. Dispositif de conversion de courant à compensation selon les revendications 1 ou 2,
**caractérisé en ce que**
3.1 l'étage de régulation (R) et/ou les étages amplificateurs (C1, C2, V, IV) sont commandés par une commande de verrouillage (LK) qui surveille notamment la symétrie de la tension d'alimentation positive et la tension d'alimentation négative (P15, N15) et le poids de sommation du régulateur pour déceler les valeurs irrégulières.

4. Dispositif de conversion de courant à compensation selon les revendications 1, 2, 3,
**caractérisé en ce que**
4.1 le courant primaire (i1) passe dans un enroulement du noyau annulaire magnétique (RK) notamment un noyau avec un entrefer,
4.2 le courant de compensation (ia) passe dans plusieurs enroulements du même noyau magnétique (RK).

5. Dispositif de conversion de courant à compensation selon l'une quelconque des revendications 1 à 4,
**caractérisé en ce que**
5.1 la fréquence d'horloge (f) est prédéterminée dans une plage comprise entre 100KHz et 200KHz.

6. Dispositif de conversion de courant à compensation selon l'une quelconque des revendications 1 à 5,
**caractérisé en ce que**
6.1 la fréquence d'horloge (f) est fournie par un oscillateur (O) excitant le capteur de champ magnétique (S).

7. Dispositif de conversion de courant à compensation selon l'une quelconque des revendications 1 à 6,
**caractérisé en ce que**
7.1 des moyens sont prévus pour générer des signaux impulsion/pause à largeur d'impulsion modulée pour commander la cadence.

8. Dispositif de conversion de courant à compensation selon la revendication 7,
**caractérisé par**
8.1 deux comparateurs (C1, C2) pour régler le rapport de travail (impulsion/pause).

9. Dispositif de conversion de courant à compensation selon l'une quelconque des revendications 1 à 7,
**caractérisé en ce qu'**
il comprend
9.1 une électronique intégrable dans un circuit intégré spécifique à l'application.
